(19) **Europäisches Patentamt / European Patent Office / Office européen des brevets**

(11) **EP 1 596 640 B1**

(12) **FASCICULE DE BREVET EUROPEEN**

(45) Date de publication et mention
de la délivrance du brevet:
**08.08.2007 Bulletin 2007/32**

(51) Int Cl.:
*H05K 1/00* (2006.01)       *H01R 12/04* (2006.01)
*H01R 29/00* (2006.01)

(21) Numéro de dépôt: **05290941.3**

(22) Date de dépôt: **29.04.2005**

(54) **Brassage par permutations utilisant des circuits imprimés configurables**

Querverbindung durch Permutationen mittels konfigurierbarer Leiterplatten

Cross-connection by permutations using configurable printed circuit boards

(84) Etats contractants désignés:
**AT BE BG CH CY CZ DE DK EE ES FI FR GB GR
HU IE IS IT LI LT LU MC NL PL PT RO SE SI SK TR**

(30) Priorité: **03.05.2004 FR 0404695**

(43) Date de publication de la demande:
**16.11.2005 Bulletin 2005/46**

(73) Titulaires:
• **LABINAL**
  **78180 Montigny-le-Bretonneux (FR)**
• **AIRBUS France**
  **31060 Toulouse Cedex 03 (FR)**

(72) Inventeurs:
• **Dunand, Michel**
  **31130 Balma (FR)**
• **Carrillo, Jean-Jacques**
  **82000 Montauban (FR)**

(74) Mandataire: **Barbin le Bourhis, Joël et al
Cabinet Beau de Loménie,
158, rue de l'Université
75340 Paris Cedex 07 (FR)**

(56) Documents cités:
WO-A-00/25392          US-A- 4 859 806
US-A- 4 889 961          US-A- 5 442 170
US-A- 5 701 234

**EP 1 596 640 B1**

## Description

L'invention concerne un procédé pour réaliser un câblage électrique biunivoque et personnalisé entre N fils entrant dans un boîtier de connexion et N fils en sortant.

Cette opération de câblage est également appelé « brassage » dans le présent mémoire.

Les boîtiers de connexions ou d'interconnexions sont destinés aux raccordements des harnais électriques équipant notamment des avions et à la mise en configuration électrique de ces avions sans modification des harnais électriques existants ce qui permet d'obtenir des câblages adaptés aux demandes des clients.

Classiquement, on utilise en aéronautique des systèmes de câblages utilisant des harnais de fils électriques. Ces derniers sont réalisés à la demande en fonction des besoins du client. ils sont donc différents d'un avion à l'autre selon les spécificités des besoins et contiennent un grand nombre de dérivations. Le brassage entre différents harnais est alors réalisé au niveau des prises de coupures qui se trouvent concentrées aux frontières des tronçons de l'avion.

Pour simplifier la fabrication des harnais il est apparu plus judicieux, notamment dans le domaine des hélicoptères, de concentrer les dérivations et brassages entre prises à l'intérieur de boîtiers de câblage. Ces boîtiers de câblage peuvent être réalisés soit par juxtaposition de petits harnais spécifiques soit par « wrapping ». La réalisation du câblage des boîtiers peut alors devenir très complexe. Ces câblages sont lourds, encombrants, coûteux, et différents d'un aéronef à l'autre

Récemment il est apparu intéressant d'utiliser des nappes de fils à la place des harnais filaires traditionnels. Il en résulte des impossibilités de brassage à l'intérieur des connecteurs, puisque les fils sont ordonnés, et des difficultés de réalisation des dérivations.

Le document WO 00/25392 A concerne un procédé de codage utilisant ponts de contact permettant de connecter des bornes d'entrée et des bornes de sortie conforme une valence de codage prédéterminé.

Le but de l'invention est de proposer un procédé qui permette, simplement et à peu de frais, un brassage et une dérivation, facilement configurables, dans des boîtiers d'interconnexions ayant N fils en entrée et N fils en sortie.

Le but est atteint selon l'invention par les étapes suivantes :

on utilise un panneau de circuit imprimé ayant N bornes d'entrée et N bornes de sorties reliées par un réseau de pistes et comportant une pluralité de dispositifs élémentaires de connexion reliant deux entrées voisines prises sur deux pistes à deux sorties voisines prises sur les mêmes deux pistes, de telle manière que lesdites deux entrées soient reliées électriquement aux dites deux sorties, d'une part, par deux liaisons directes, constituées par des portions de ces deux pistes, et, d'autre par, par deux liaisons de dérivation croisées, afin que chaque borne d'entrée soit électriquement reliée à toutes les bornes de sortie, et chaque borne de sortie à toutes les bornes d'entrée,
on personnalise ledit panneau en coupant dans chaque dispositif élémentaire de connexion soit les liaisons directes, soit les liaisons de dérivation, afin d'obtenir un câblage électrique biunivoque et personnalisé entre les N bornes d'entrée et les N bornes de sortie dudit panneau, le nombre et la disposition desdits dispositifs étant choisis de manière à permettre toutes les combinaisons de câblage possibles, et
on monte le panneau personnalisé dans le boîtier d'interconnexion.

Le procédé de brassage selon l'invention permet de remplir les fonctions d'interconnexions à l'aide d'un circuit imprimé qui est configurable, en lieu et place des brassages traditionnelles, par l'utilisation de dispositifs élémentaires de connexion qui permettent chacun une permutation électrique entre deux pistes.

L'invention concerne également un panneau de circuit imprimé pour la mise en oeuvre du procédé.

Ce panneau de circuit imprimé est caractérisé par le fait qu'il comporte N bornes d'entrée et N bornes de sortie, les bornes d'entrée et les bornes de sortie étant reliées par un réseau de pistes, les pistes étant reliées entre elles par une pluralité de dispositifs élémentaires de connexion à deux entrées deux sorties disposées entre des portions voisines de deux pistes, les deux entrées d'un dispositif étant reliées électriquement aux deux sorties dudit dispositif, d'une part, par deux liaisons directes constituées par lesdites portions, et, d'autre part, par deux liaisons de dérivation croisés, afin que chaque borne d'entrée soit électriquement reliée à toutes les bornes de sortie et chaque borne de sortie à toutes les bornes d'entrée, le nombre et la disposition desdits dispositifs étant choisis de manière à permettre toutes les combinaisons de câblage possibles en coupant dans chaque dispositif élémentaire de connexion soit les liaisons directes, soit les liaisons de dérivation.

Avantageusement, les bornes d'entrée sont disposés sur un bord du panneau et les bornes de sortie sur un autre bord, notamment sur le bord opposé.

De préférence, les portions de piste constituant les liaisons directes d'un dispositif de connexion sont disposées en superposition sur les faces opposées du panneau de circuit imprimé. Ceci permet par un seul perçage de couper les deux liaisons directes d'un dispositif élémentaire de connexion.

Selon une caractéristique avantageuse de l'invention, les liaisons croisées sont réalisées au moyen de deux vias disposés latéralement à distance des liaisons directes et raccordés électriquement à ces dernières. La destruction de ces deux vias par perçage permet de couper les deux liaisons de dérivation d'un dispositif élémentaire de connexion sans risque d'abîmer les pistes adjacentes

Afin de protéger les trous et les réseaux contre les salissures et les claquages électriques, les trous du panneau sont bouchés à l'aide d'une résine polymérisable. Les deux faces sont également enduites par une résine de protection.

Selon une disposition particulière de l'invention, les dispositifs élémentaires de connexions sont répartis sur une pluralité d'étages de permutateurs d'ordre n entre les entrées et les sorties, un permutateur d'ordre n permettant de réaliser un câblage biunivoque entre n entrées et n sorties.

Très avantageusement le panneau de circuit imprimé comporte trois étages de permutateurs d'ordre n, les entrées des permutateurs du premier étage étant directement reliées électriquement aux bornes d'entrée, les sorties des permutateurs du dernier étage étant directement reliées électriquement aux bornes de sortie, et, entre deux étages successifs, les sorties de chaque permutateur de l'étage de rang inférieur sont reliées électriquement respectivement à une entrée de chacun des permutateurs de l'étage de rang supérieur.

De plus, les permutateurs d'ordre n peuvent être disposés symétriquement par rapport à un axe longitudinal. Ils peuvent aussi être disposés symétriquement par rapport à un axe transversal.

D'autres avantages et caractéristiques de l'invention ressortiront à la lecture de la description suivante faite à titre d'exemple et en référence aux dessins annexés dans lesquels :

La figure 1 montre schématiquement les liaisons filaires biunivoques à réaliser entre les entrées et les sorties dans un boîtier de connexion ;

La figure 2 montre un panneau d'un circuit imprimé de type matriciel réalisé avant la personnalisation ;

La figure 3 montre le panneau de la figure 2 après la personnalisation ;

La figure 4 montre un circuit imprimé , ayant trois entrées et trois sorties, réalisé avec trois permutateurs du type 2 entrées/2sorties ;

La figure 5 montre un circuit imprimé , ayant quatre entrées et quatre sorties, réalisé avec cinq permutateurs du type 2 entrées/2sorties ;

La figure 6 montre une variante du circuit imprimé de la figure 4 dans laquelle les redondances sont éliminées ;

La figure 7 montre un circuit imprimé à huit entrées et huit sorties réalisé sous la forme d'un réseau de Benes ;

La figure 8 montre la partie gauche d'un circuit imprimé à seize entrées et seize sorties réalisé sous la forme d'un réseau de Benes ;

La figure 9 montre schématiquement un permutateur ayant deux entrées et deux sorties ;

La figure 10 montre des réseaux équivalents ;

La figure 11 montre les liaisons directes et inversées dans un permutateur deux entrées et deux sorties ;

La figure 12 montre un exemple de permutateur d'ordre 5 ;

La figure 13 montre un permutateur d'ordre 6 ayant deux axes de symétrie et trois étages de permutateurs entre les entrées et les sorties, les permutateurs de l'étage médian étant des permutateurs d'ordre 3 ;

La figure 14 montre un exemple préféré d'un permutateur d'ordre 12 ;

La figure 15a montre la face supérieure d'un circuit imprimé comportant 3 permutateurs d'ordre 2 ;

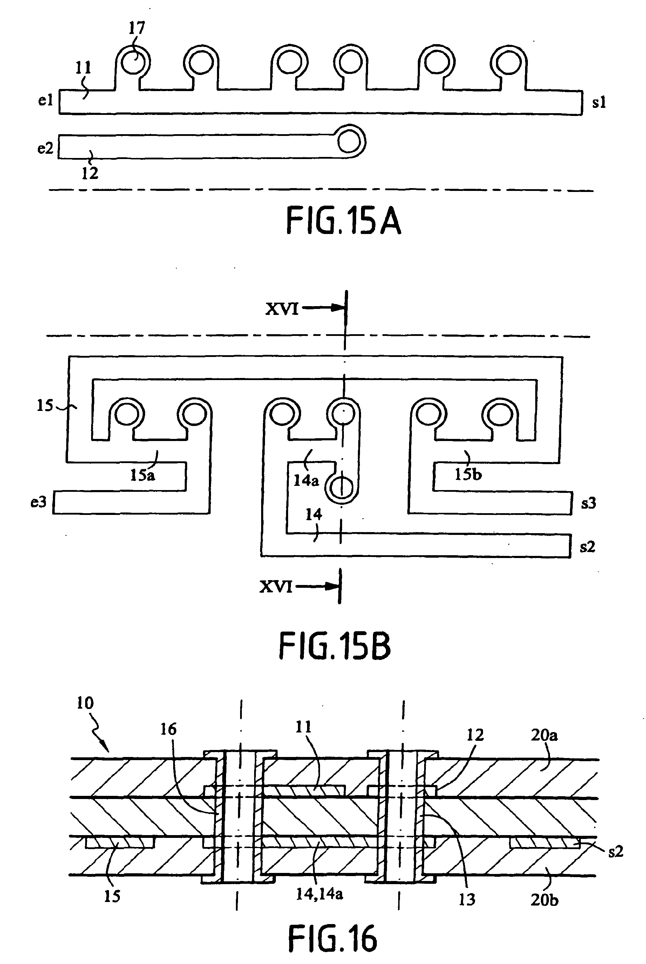

La figure 15 b montre la face inférieure du permutateur d'ordre 3 de la figure 15a ; et

La figure 16 est un coupe, selon la ligne XVI- XVI des figures 15a et 15b d'un circuit imprimé selon l'invention.

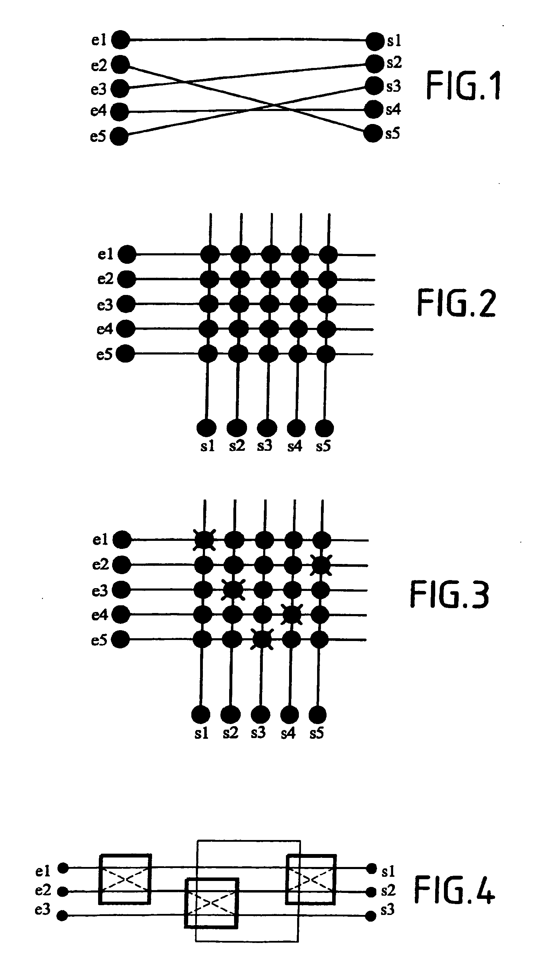

La figure 1 montre les liaisons filaires biunivoques à réaliser entre N entrées et N sorties d'un boîtier. Sur cette figure seules cinq liaisons sont montrées, par souci de clarté, mais le nombre de liaisons peut être largement supérieur à cinq et sera défini ci-après par le nombre N.

Le but de l'invention est de proposer un panneau de circuit imprimé double face, éventuellement multicouche, qui permette de réaliser toutes les solutions possibles, soit N ! (factoriel N) solutions.

Ce panneau est ensuite personnalisé pour ne retenir qu'un seul câblage parmi les N ! solutions possible, en vue d'une application particulière, notamment en aviation.

Le brassage montré sur la figure 1 comporte cinq entrées référencées e1 à e5 et cinq sorties référencées s1 à s5. Les entrées e1, e2, e3, e4 et e5 sont reliées électriquement et respectivement aux sorties s1, s5,s2 s4 et s3.

Selon l'invention, les interconnexions entre les entrées et sorties du boîtier sont réalisées à partir de circuits imprimés configurables après réalisation physique du circuit : c'est à dire que les circuits imprimés sont réalisés avec toutes les combinaisons d'interconnexions possibles puis, en reprise, est réalisé individuellement la personnalisation du circuit.

La figure 2 montre un panneau de circuit imprimé de type matriciel traditionnel, d'ordre 5, qui permet de réaliser le brassage spécifique montré sur la figure 1, ainsi que toutes les permutations possibles entre 5 fils en entrée et 5 fils en sortie. Les 5 fils en entrant dans ce circuit imprimé sont raccordés à une première nappe de 5 pistes parallèles imprimées sur une face du panneau et les 5 fils de sortie sont raccordés à une deuxième nappe de 5 pistes parallèles imprimées sur l'autre face du panneau, les pistes de la deuxième nappe étant perpendiculaires aux pistes de la première nappe. Les connexions électriques entre les 5 pistes d'entrée horizontales et les 5 pistes de sortie verticales sont réalisées à l'aide de vias, à toutes les intersections des pistes des deux nappes superposées. Chaque piste d'entrée est raccordée à toutes les pistes de sorties et chaque piste de sortie est raccordée à toutes les pistes d'entrée. Pour personnaliser le panneau de circuit imprimé ainsi réalisé, afin d'obtenir le câblage montré sur la figure 1, il suffit de supprimer par perçage, en reprise, les vias qui sont superflus, et de conserver les vias marqués d'une croix sur la figure 3.

Ce qui à été décrit ci-dessus pour un panneau de circuit imprimé ayant 5 entrées et 5 sorties est valable pour un circuit imprimé ayant N entrées et N sorties.

Mais l'utilisation d'un circuit imprimé tel que celui montré sur la figure 2 de type matriciel, que nous appellerons également de type « crossbar », pose trois problèmes :

- Les sorties sont perpendiculaires aux entrées ;
- Le nombre de perçages est important ($N^{**}2 - N$) ; et
- La surface du circuit est importante.

Le but de l'invention est de proposer un système de brassage par permutation utilisant un circuit imprimé, qui permette de résoudre les trois problèmes cités ci-dessus.

Nous définissons une permutation comme une fonction permettant d'orienter des flux d'entrée vers des flux de sortie de manière bijective.

On peut représenter ces fonctions par des matrices dites de permutations qui sont nécessairement des matrices carrées ayant des propriétés particulières :

La matrice est une matrice carrée (autant d'entrées que de sorties);
La matrice ne peut être composée que de 0 ou de 1 (matrice de commutation); et
La somme de chacune des lignes ou de chacune des colonnes de cette matrice est égale à 1 (bijective).

Voici un exemple d'une matrice de permutation/

| | | | |
|---|---|---|---|
| S1 | | 0 0 0 0 0 1 0 0 | E1 |
| S2 | | 0 1 0 0 0 0 0 0 | E1 |
| S3 | | 1 0 0 0 0 0 0 0 | E1 |
| S4 | = | 0 0 0 1 0 0 0 0 X | E1 |
| S5 | . | 0 0 0 0 0 0 0 1 | E1 |
| S6 | | 0 0 0 0 1 0 0 0 | E1 |
| S7 | | 0 0 1 0 0 0 0 0 | E1 |
| S8 | | 0 0 0 0 0 0 1 0 | E1 |

Sur le plan technologique, nous appellerons permutateur un dispositif de connexion qui permet de réaliser des permutations de circuits.

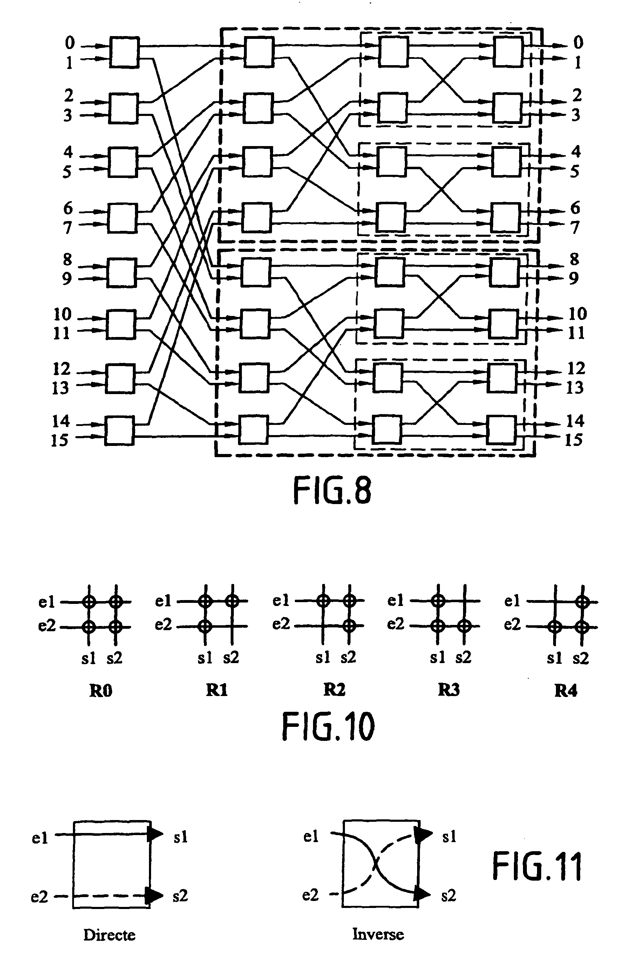

Le permutateur le plus simple, ou dispositif élémentaire de connexion, permet d'échanger 2 circuits ( 2 entrées pour 2 sorties ). Il est symbolisé comme indiqué sur la figure 9.

Selon la programmation du permutateur le plus simple, d'ordre 2, que nous noterons P(2), on pourra avoir les connexions directes (e1,s1) et (e2,s2) ou bien les connexions croisées (e1,s2) et (e2,s1).

Bien sûr, il est possible d'envisager des permutateurs d'ordre supérieur, l'ordre représentant le nombre de fils d'entrée ou de fils de sortie du permutateur.

Le nombre de permutations possibles pour un ordre n est de n!.

Ce nombre est plus petit que le nombre de combinaisons possibles d'une matrice de type crossbar. En effet, cette dernière est capable de réaliser $2^{**}(n^2)$ combinaisons différentes pour un profil à n entrées et n sorties. On ne peut pas pour autant considérer que la matrice est plus puissante en terme de topologie, en effet de nombreuses combinaisons sont inutiles. On peut prendre pour exemple les redondances obtenues en reliant l'entrée e1 aux sorties s1 et s2 et en reliant l'entrée e2 aux mêmes sorties sur un réseau de commutation d'ordre 2 que nous appellerons R0. Il est en effet facile de démontrer que ce réseau est équivalent aux quatre réseaux suivants :

R1, où e1 et relié à s1 et s2 et où e2 n'est relié qu'à s1
R2, où e1 et relié à s1 et s2 et où e2 n'est relié qu'à s2
R3, où e2 et relié à s1 et s2 et où e1 n'est relié qu'à s1
R4, où e2 et relié à s1 et s2 et où e1 n'est relié qu'à s2

Ces équivalences sont représentées sur la figure 10.

Les permutations n'assurant que les liaisons bijectives, il ne devrait pas exister de redondances.

Les seules possibilités pour un ordre 2 sont représentées sur la figure 11.

Ces remarques laissent percevoir un gain substantiel en surface de circuit imprimé.

Bien entendu, il est possible de réaliser des permutateurs pour 3, 4 ou plus d'entrées. Il ne faut tout de même pas oublier que pour programmer ces différents permutateurs, il existe n! solutions, soient 6 possibilités pour un permutateur d'ordre 3, 24 pour un permutateur d'ordre 4 et 120 pour un permutateur d'ordre 5.

On peut définir la matrice de permutation précédente comme étant une matrice de commutation logique. On peut lui associer 2 opérations qui sont la mise en parallèle des circuits d'une part et la mise en série d'autre part.

La mise en parallèle est une opération courante en électricité, et elle se traduit directement en pratique par un ou logique des matrices de commutations correspondantes.

On a donc un moyen simple de réaliser, à partir de permutations, des dérivations électriques dont la quantité (l'ordre de dérivation) est facilement maîtrisable.

La mise en série de deux permutateurs donne un permutateur combiné et n'a à priori pas d'intérêt si on réalise des permutateurs à n entrées et n sorties.

On peut se poser la question suivante : est-il possible de réaliser des permutateurs d'ordre quelconque à partir de permutateurs d'ordre moins élevé ?

On peut en effet réaliser un permutateur d'ordre 3 à partir de permutateurs d'ordre 2. Cette construction peut se faire de manière purement intuitive.

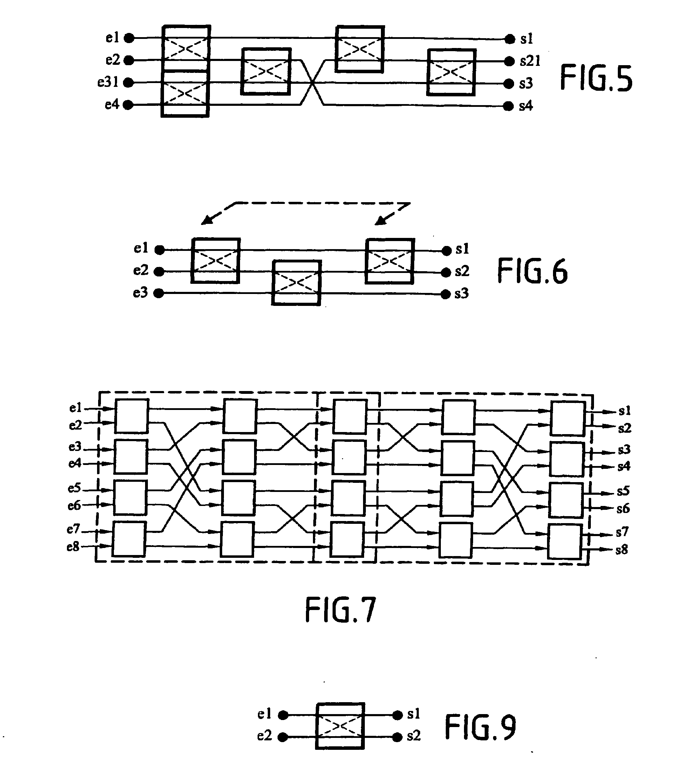

Un exemple est représenté sur la figure 4. Il est possible de trouver d'autres combinaisons avec 3 permutateurs ou plus, mais il est impossible de réaliser un permutateur de 3 entrées avec seulement 2 permutateurs à 2 entrées.

En effet, pour réaliser la permutation d'ordre 3 de manière exhaustive, il faut pouvoir réaliser au moins 6 combinaisons (3 !). Un permutateur d'ordre 2 est capable de réaliser 2 combinaisons (direct et inverse), avec 2 permutateurs, on obtient $2^{**}2 = 4$ combinaisons possibles, il en faut donc bien au moins 3, ce qui donne $2^{**}3 = 8$ combinaisons. Il y a donc 2 combinaisons redondantes dans ce schéma qui sont :

$$(e1,e2,e3) = (s1,s2,s3) \text{ et } (e1,e2,e3) = (s2,s1,s3)$$

La matrice d'ordre 3, de type crossbar, réaliserait $2^{**}9 = 512$ combinaisons possibles.

Pour un ordre 4, qui représente 24 combinaisons, il faut au moins 2 permutateurs de plus (en effet, $2^{**}4 = 16$, mais $2^{**}5 = 32$). On peut réaliser le schéma montré sur la figure 5, qui permet de réaliser les 24 combinaisons requises avec 5 permutateurs.

Il existe bien d'autres solutions, il suffit par exemple d'inverser le rôle des 2 sorties (ou entrées) d'un des permutateurs pour retrouver un schéma qui remplit les conditions recherchées. En effet, le fonctionnement initial de chacune des 2 sorties s'obtient en programmant le permutateur concerné dans l'autre sens.

On trouve encore des redondances dans le permutateur d'ordre 4 puisqu'il existe 32 combinaisons possibles pour 24 utiles.

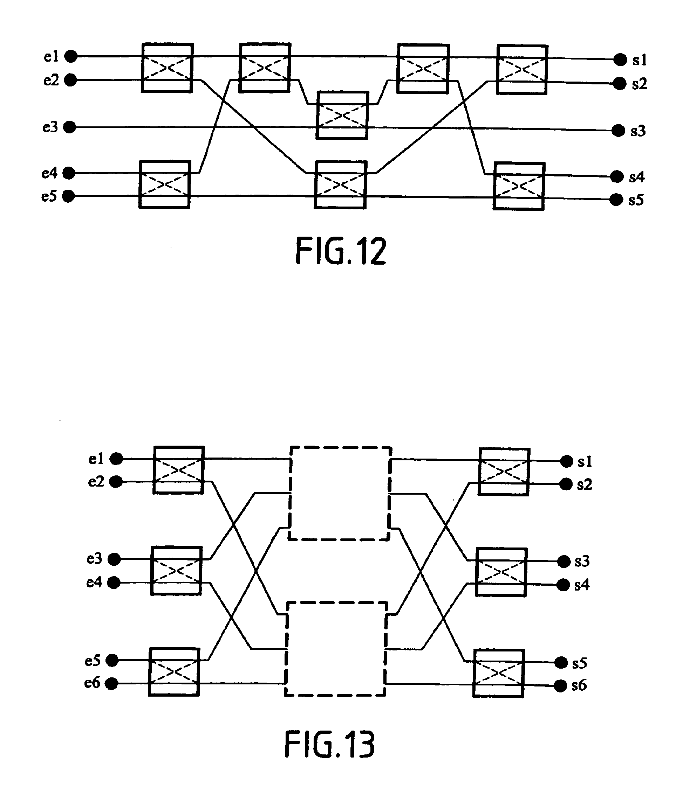

Si on continue ce raisonnement, on peut espérer trouver un optimum pour des permutateurs de certains ordres. Ainsi, un permutateur d'ordre 5 représente 5! combinaisons, c'est-à-dire 120 combinaisons. On peut se demander s'il est possible de le réaliser avec 7 permutateurs d'ordre 2 (soit 128 combinaisons) . On remarque alors que pour cette valeur particulière de 5!, la différence de 8 combinaisons serait très favorable. Ce qui est certain, c'est qu'on peut le réaliser avec 8 permutateurs d'ordre 2, ainsi que cela est montré sur la figure 12. Pour personnaliser le circuit imprimé à 5 entrées et 5 sorties, il suffit de supprimer les liaisons directes ou inversées de 8 permutateurs d'ordre 2, alors que sur le circuit du type crossbar, montré sur la figure 3, il faut supprimer 20 vias, pour obtenir le même brassage.

Le permutateur d'ordre 6 est réalisé, de préférence, ainsi que cela est montré sur la figure 13, par des permutateurs d'ordre 2 et des permutateurs d'ordre 3. Les 6 lignes d'entrées entrent dans trois permutateurs d'ordre 2, représentés à gauche sur la figure 13. Une sortie de chacun de ces permutateurs d'ordre 2 entre dans un permutateur supérieur d'ordre 3, tandis que les autres sorties de ces permutateurs d'ordre 2 entrent dans un permutateur inférieur d'ordre 3. Les trois sorties du permutateur supérieur d'ordre 3 sont raccordées à trois permutateurs d'ordre 2, situés à droite sur la figure 13, tandis que les trois sorties du permutateur inférieur d'ordre 3 sont raccordées à ces mêmes permutateurs d'ordre 2. Le permutateur d'ordre 6 comporte ainsi en tout 12 permutateurs d'ordre 2, qui doivent être personnalisés par rupture des liaisons directes ou des liaisons inversées, alors qu'avec un circuit imprimé de type crossbar à 6 entrées et 6 sorties, du type de celui montré sur la figure 3, il faut supprimer 30 vias.

Le permutateur d'ordre 6, réalisé de cette manière présente la particularité d'être symétrique par rapport à un axe médian vertical et par rapport à un axe médian horizontal, à condition de faire en sorte que les deux permutateurs d'ordre 3 soient dessinés symétriquement par rapport à cet axe médian horizontal. Ce permutateur d'ordre 6 comporte trois étages de permutateurs , l'étage médian étant constitué par deux permutateurs d'ordre 3., tandis que l'étage d'entrée et l'étage de sortie ne comportent que des permutateurs d'ordre 2.

Le principe utilisé pour dessiner le permutateur d'ordre 6 = 2*3 est valable pour tout permutateur d'ordre N = a*b, dans lequel a est inférieur ou égal à b.

Pour un tel permutateur d'ordre N = a*b, Les N lignes d'entrées sont raccordées à b permutateurs d'ordre a, disposés à gauche du circuit imprimé près des bornes d'entrée. Une sortie de chacun de ces permutateurs de gauche d'ordre a entre dans un permutateur médian d'ordre b, le nombre de permutateurs d'ordre b étant a, et chaque permutateur d'ordre a de gauche étant relié à tous les permutateurs médians. Les sorties de chaque permutateur médian d'ordre b sont raccordées à tous les permutateurs d'ordre a, situés à droite du circuit imprimé près des sorties et qui sont au nombre de b.

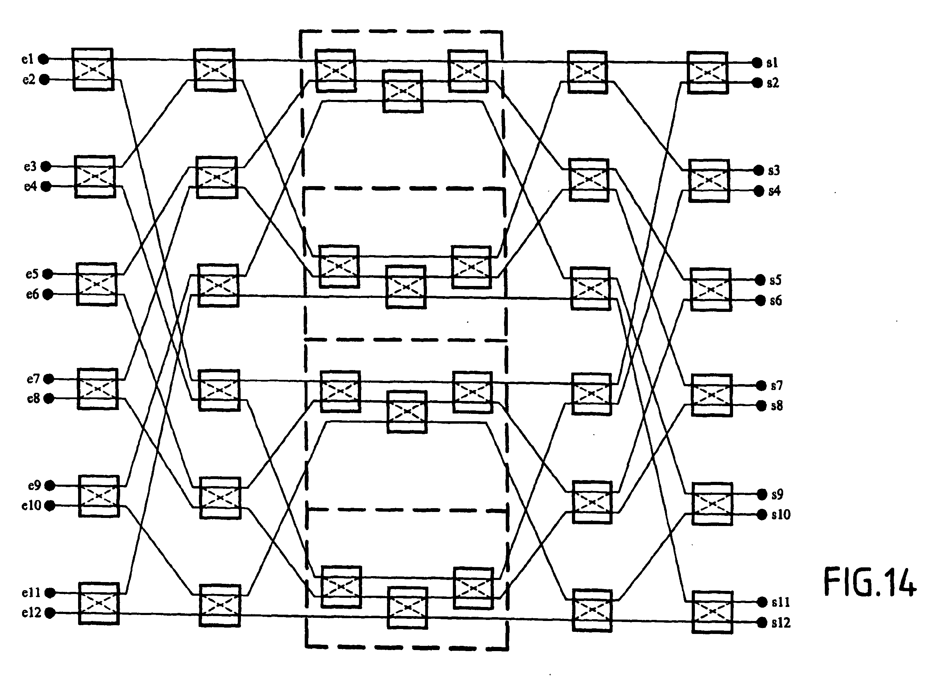

Dans le cas où N = 12 = 2*6, on voit que le permutater d'ordre 12 peut être réalisé comme cela est représenté sur la figure 14. Ce permutateur d'ordre 12 comporte 36 permutateurs élémentaires d'ordre 2 qui doivent être personnalisés, alors qu'une connexion de type crossbar avec 12 entrées et 12 sorties présenterait 144 (12**2) vias dont 132 seraient à supprimer.

Si N = 144 = 12*12, le circuit imprimé présente 3 colonnes de 12 permutateurs d'ordre 12, soit 1296 (36*36) permutateurs d'ordre 2, alors qu'une connexion de type crossbar, logiquement identique, aurait 20736 (144**2) vias dont 20592 (144**2 - 144) seraient à supprimer. Il est probale qu'un permutateur d'ordre 144 puisse être réalisé avec moins de 1296 permutateurs d'ordre 2, mais il serait alors difficile d'obtenir des symétries par rapport à un axe médian vertical et à un axe médian horizontal, et l'élaboration du circuit à imprimer ainsi que sa vérification serait nettement plus délicats.

Il est probablement possible de réaliser des permutateurs d'ordre 12 ayant moins de 36 permutateurs, mais il en faut au moins 29, car le nombre de permutateurs minimum nécessaire M se calcule de la façon suivante :

$$M = Log2(12 \ !) = 28,83..$$

On en déduit que M=29

Les opérations précédentes présentent de l'intérêt. En effet, la surface de cuivre nécessaire pour réaliser une matrice de 12 par 12 est de 144 surfaces élémentaires pour réaliser une jonction. Si donc un permutateur tient dans une surface de cuivre inférieure à celle d'une jonction de matrice multipliée par un coefficient pondérateur égal à 144/29=4,96, alors on pourra affirmer que la surface de cuivre pour des permutations sera plus petite que la surface de cuivre pour des matrices.

Cette valeur devient encore plus intéressante pour des ensembles de nappes. Avec 72 fils d'entrée et 72 fils de sortie, le brassage selon le procédé de l'invention représenterait une surface équivalente à 345 permutateurs élémentaires au lieu des 5184 liaisons élémentaires d'une matice de type crossbar. On voit, dans ce cas que le rapport élémentaire est de 15, ce qui permet de penser que même avec une surface de permutateur équivalente à 3 fois la surface d'une liaison matricielle, le gain de surface serait important (gain de 5).

On peut réaliser tout un circuit de brassage à l'aide de permutateurs sur un circuit imprimé. L'idée est alors, dans un dispositif élémentaire de connexion, soit de relier les entrées aux sorties en direct ou en inverse, ou au contraire en supprimant les liaisons directes ou inverses préétablies dans le circuit. C'est cette dernière solution qui est de préférence retenue. Car on peut supprimer facilement deux liaisons ( les liaisons directes ou les liaisons inverses) de façon simultanées, par perçage par exemple. La technologie consistera donc à réaliser des permutateurs configurables par rupture des liaisons inutilisées.

On utilise des permutateurs d'ordre 2. Mais si on obtient quelquefois des redondances, c'est que dans certains cas, les permutateurs devraient être liés. Dans le cas du permutateur d'ordre 3 par exemple, les 8 possibilités se réduiraient à 6 si on pouvait lier le premier et le dernier des permutateurs de la figure 4 en leur interdisant d'être simultanément inversés. C'est exactement ce qui peut être réalisé avec du circuit imprimé multi-couches, comme cela est montré sur la figure 6.

Cette solution est tout à fait envisageable (3 trous de programmation au lieu de 2 par permutateur, ce qui donne 3X2=6 combinaisons). Ce qui fait que lorsqu'on programme le permutateur 2 en inverse, on programme du même coup le permutateur 1 en direct.

On peut étendre cette possibilité à des ensembles plus complexes de permutateurs et lier certains d'entre eux par 2, 3 ou plus.

Ces remarques permettent d'envisager des solutions plus compactes, avec probablement une augmentation du nombre de couches de cuivre sur le circuit imprimé, mais surtout elles ouvrent une nouvelle voie pour l'architecture des circuits qui sont difficiles à réaliser au-delà de l'ordre 4 de façon intuitive.

Un cas particulier de circuit imprimé est celui où le nombre d'entrées et de sorties est une puissance de 2. Dans ce cas on peut utiliser un réseau de permutateurs d'ordre 2 semblable à un réseau de Benes utilisé en télécommunication et qui correspond à un ensemble récurrent de permutateurs d'ordre 2r, dont le modèle générique est issu du réseau Baseline d'ordre 2. La figure 8 montre la constitution d'un Baseline à 16 entrées

On peut construire un ensemble réarrangeable de type Bénes par symétrisation puis réduction d'un réseau Baseline. La figure 7 montre un réseau de Benès à 8 entrées/sorties qui comporte 5 étages de 4 commutateurs. En remplaçant les commutateurs de ce réseau par les permutateurs deux entrées et deux sorties décrits ci-dessus, on obtient un circuit imprimé susceptible d'être personnalisé pour fournir un câblage choisi parmi factoriel 8 combinaisons. Ce permutateur comporte alors un étage d'entrée ayant 4 commutateurs d'ordre 2, un étage médian ayant 2 permutateurs d'ordre 4 et un étage de sortie semblable à l'étage d'entrée, les permutateurs d'ordre 4 comportant chacun 6 permutateurs d'ordre 2, alors que 5 permutateurs d'ordre 2 suffisent, mais qui sont disposés symétriquement par rapport à un axe horizontal et à un axe vertical.

Dans un réseau de Benes d'ordre r, le nombre d'étages est égal à 2r-1, et le nombre de commutateurs par étage est de $2^{**}(r-1)$ Le nombre total permutateurs est de $(2^{**}(r-1))^*(2r-1)$ ou : N/2*(2* Log2(N)-1)

L'amélioration de ce type de réseau est considérable par rapport à une matrice et le design est très simplifié par rapport à un réseau optimisé en nombre de permutateurs.

Selon l'invention, on peut adopter cette façon générique de réaliser la matrice de permutateurs en remplacement des commutateurs du réseau de Benes par des permutateurs à deux entrées et deux sorties fonctionnant en liaison directe ou en liaison inverse.

Le calcul montre que pour 72 entrées sorties, il faut : 409 permutateurs, alors qu'une réalisation optimisée en nécessiterait 345. Le gain de surface de l'ordre de 15% ne vaut pas la difficulté et les risques à dessiner le circuit optimisé, d'autant que, si le circuit est plus complexe, les liaisons occuperont plus de surface.

La réalisation d'un réseau de type Benes se fait pour des nombres d'entrées/sorties de la forme $2^N$. Or il est relativement aisé de réduire un réseau de Benes pour un nombre quelconque d'entrées/sorties en partant du réseau $2^N$ immédiatement supérieur ou égal à ce nombre. Ainsi, avec 72 entrées/sorties, on réduira un réseau de Benès ayant 128 entrées sorties. Dans ce cas, la formule permettant de calculer le nombre de permutateurs nécessaires fonctionne encore très bien (bien que plus approximative).

En supposant que la réalisation d'un permutateur sur un circuit imprimé vaut 3 fois la surface élémentaire d'une jonction matricielle, le gain de surface de circuit pour 72 entrées/sorties sera de (72*72)/(409*3)>4.

Les dérivations sont obtenues en combinant sur un même permutateur choisi pour ses propriétés de convergence de circuits les liaisons directes et inverses. Il suffit donc de laisser conduire ces deux types de liaisons pour obtenir une connexion de circuits. Comme tout brassage est possible, toute dérivation est possible.

Les figures 15a, 15b et 16 montrent un exemple de réalisation d'un circuit imprimé comportant notamment un permutateur d'ordre 3 ayant les entrées e1, e2 et e3.et les sorties s1, s2 et s3. Sur la face supérieure de la plaque 10 constituant le panneau du circuit imprimé, sont gravés deux pistes parallèles 11 et 12 sensiblement rectilignes. L'extrémité de la piste 12 est relié par un via 13 à l'extrémité d'une piste 14 gravée sur la face inférieure de la plaque 10 et reliée à la sortie s2. Sur cette face inférieure est en outre gravée une piste 15 raccordée a l'entrée e3 et à la sortie s3. La piste 15 présente deux portions rectilignes 15a et 15b situées sous la piste 11. la piste 14 comporte également une portion rectiligne 14a sous la piste 11, entre les portions 15a et 15b. Latéralement à ces portions 15a, 15 b et 14a sont prévus des vias 16 raccordés aux extrémités de ces portions. Ces vias débouchent sur la face supérieure de la plaque en des endroits 17 raccordés à la piste 11 et sont formés par des trous dont les parois sont métallisées par des procédés de métallisation connus. La plaque 10 avec ses réseaux de pistes supérieur et inférieur est prise en sandwich entre deux flans en matériau isolant qui rigidifient le circuit imprimé et protègent les pistes. Pour réaliser les vias 13 et 16 on réalise des trous à travers les flans 20a, 20b et la plaque 10 et on procède à la métallisation des parois des trous. Le circuit imprimé comporte alors trois dispositifs élémentaires de connexion. On comprend aisément que dans cet état les entrées e1, e2,e3, et les sorties s1, s2, s3 sont en court-circuit .

Pour personnaliser ce permutateur d'ordre 3 on rompt, par perçage, dans chaque dispositif élémentaire de connexion, soit les liaisons directes soit les deux vias 16 associes. On remplit ensuite les trous par un matériau isolant. Le via 13 qui fait partie intégrante de la piste d'entrée e1 est quant à lui toujours conservé

**Revendications**

1.  Procédé pour réaliser un câblage électrique biunivoque et personnalisé entre N fils entrant dans un boîtier de connexion et N fils en sortant **caractérisé par l**es étapes suivantes :

on utilise un panneau de circuit imprimé ayant N bornes d'entrée et N bornes de sorties reliées par un réseau de pistes et comportant une pluralité de dispositifs élémentaires de connexion reliant deux entrées voisines prises sur deux pistes à deux sorties voisines prises sur les mêmes deux pistes, de telle manière que lesdites deux entrées soient reliées électriquement aux dites deux sorties, d'une part, par deux liaisons directes, constituées par des portions de ces deux pistes, et, d'autre part, par deux liaisons de dérivation croisées, afin que chaque borne d'entrée soit électriquement reliée à toutes les bornes de sortie, et chaque borne de sortie à toutes les bornes d'entrée,

on personnalise ledit panneau en coupant dans chaque dispositif élémentaire de connexion soit les liaisons directes, soit les liaisons de dérivation, afin d'obtenir un câblage électrique biunivoque et personnalisé entre les N bornes d'entrée et les N bornes de sortie dudit panneau, le nombre et la disposition desdits dispositifs étant choisis de manière à permettre toutes les combinaisons de câblage possibles, et

on monte le panneau personnalisé dans le boîtier d'interconnexion.

**2.** Panneau de circuit imprimé pour la mise en oeuvre du procédé selon la revendication 1 **caractérisé par le fait qu**'il comporte N bornes d'entrée et N bornes de sortie, les bornes d'entrée et les bornes de sortie étant reliées par un réseau de pistes, les pistes étant reliées entre elles par une pluralité de dispositifs élémentaires de connexion à deux entrées deux sorties disposées entre des portions voisines de deux pistes , les deux entrées d'un dispositif étant reliées électriquement aux deux sorties dudit dispositif , d'une part, par deux liaisons directes constituées par lesdites portions, et, d'autre part, par deux liaisons de dérivation croisées, afin que chaque borne d'entrée soit électriquement reliée à toutes les bornes de sortie et chaque borne de sortie à toutes les bornes d'entrée, le nombre et la disposition desdits dispositifs étant choisis de manière à permettre toutes les combinaisons de câblage possibles en coupant dans chaque dispositif élémentaire de connexion soit les liaisons directes, soit les liaisons de dérivation.

**3.** Panneau selon la revendication 2 **caractérisé par le fait que** les bornes d'entrée sont disposés sur un bord du panneau et les bornes de sortie sur un autre bord, notamment sur le bord opposé.

**4.** Panneau selon l'une des revendications 2 ou 3 **caractérisé par le fait que** des portions de piste constituant des liaisons directes ou des liaisons croisées d'un dispositif de connexion sont disposées en superposition sur les faces opposées du panneau de circuit imprimé.

**5.** Panneau selon l'une l'une des revendications 2 à 4 **caractérisé par le fait que** des liaisons sont réalisées au moyen de vias disposés latéralement à distance des liaisons directes ou des liaisons croisées et raccordés à ces dernières.

**6.** Panneau selon l'une quelconque des revendications 2 à 5 **caractérisé par le fait que**, dans chaque dispositif élémentaire de connexion, des liaisons directes ou des liaisons de dérivation sont coupées en faisant des trous à travers ledit panneau.

**7.** Panneau selon la revendications 6 **caractérisé par le fait que** les trous sont bouchés par une résine isolante.

**8.** Panneau selon l'une quelconque des revendications 2 à 7 **caractérisé par le fait que** les dispositifs élémentaires de connexions sont répartis sur une pluralité d'étages de permutateurs d'ordre n disposés entre les entrées et les sorties, un permutateur d'ordre n permettant de réaliser un câblage biunivoque entre n entrées et n sorties.

**9.** Panneau selon la revendication 8 **caractérisé par le fait qu**'il comporte trois étages de permutateurs d'ordre n, les entrées des permutateurs du premier étage étant directement reliées électriquement aux bornes d'entrée, les sorties des permutateurs du dernier étage étant directement reliées électriquement aux bornes de sortie, et, entre deux étages successifs, les sorties de chaque permutateur de l'étage de rang inférieur sont reliées électriquement respectivement à une entrée de chacun des permutateurs de l'étage de rang supérieur.

**10.** Panneau selon la revendication 9 **caractérisé par le fait que** les permutateurs d'ordre n sont disposés symétriquement par rapport à un axe longitudinal.

**11.** Panneau selon la revendication 10 **caractérisé par le fait que** les permutateurs d'ordre n sont disposés symétriquement par rapport à un axe transversal.

**Claims**

1.  A method of implementing personalized one-to-one electrical wiring between N input wires to a junction box and N output wires therefrom, the method being **characterised by** the following steps:

    .making a printed circuit panel having N input terminals and N output terminals interconnected by a network of tracks and comprising a plurality of individual connection devices each connecting two adjacent inputs taken from two of the tracks to two adjacent outputs taken from the same two tracks, so that said two inputs are electrically connected to said two outputs, firstly by direct connections constituted by portions of said tracks, and secondly by two crossed-over branch connections, such that each input terminal is electrically connected to all of the output terminals, and each output terminal is electrically connected to all of the input terminals;
    . personalizing said panel by interrupting in each individual connection device either its direct connections or its branch connections so as to obtain personalized one-to-one electrical wiring between the N input terminals and the N output terminals of said panel, the number and the disposition of said devices being selected in such a manner as to make all possible wiring combinations possible; and
    .mounting the personalized panel in a junction box.

2.  A printed circuit panel for implementing the method according to claim 1, the panel being **characterised by** the fact that it comprises N input terminals and N output terminals, the input terminals and the output terminals being interconnected by a network of tracks, the tracks being interconnected by a plurality of individual two input and two output connection devices disposed between adjacent portions of two tracks, the two inputs of one device being electrically connected to the two outputs of said device firstly by two direct connections constituted by said track portions, and secondly by two crossed-over branch connections, such that each input terminal is electrically connected to all of the output terminals and each output terminal is electrically connected to all of the input terminals, the number and the disposition of said devices being selected in such a manner as to enable all possible wiring combinations to be implemented by interrupting in each individual connection device either the direct connections or the branch connections.

3.  A panel according to claim 2, **characterised by** the fact that the input terminals are disposed on one edge of the panel and the output terminals on another edge, in particular the opposite edge.

4.  A panel according to claim 2 or claim 3, **characterised by** the fact that the track portions constituting the direct connections or the crossed-over connections of a connection device are superposed on opposite faces of the printed circuit panel.

5.  A panel according to one of claims 2 to 4, **characterised by** the fact that the connections are made by means of vias that are disposed laterally so as to be offset from the direct connections or the crossed-over connections, and that are connected thereto.

6.  A panel according to any one of claims 2 to 5, **characterised by** the fact that in each individual connection device, the direct connections or the branch connections are interrupted by drilling holes through said panel.

7.  A panel according to claim 6, **characterised by** the fact that the holes are plugged by an insulating resin.

8.  A panel according to any one of claims 2 to 7, **characterised by** the fact that the individual connection devices are distributed over a plurality of stages of order $n$ permutators disposed between the inputs and the outputs, a permutator of order $n$ serving to implement one-to-one wiring between $n$ inputs and $n$ outputs.

9.  A panel according to claim 8, **characterised by** the fact that it comprises three stages of permutators of order $n$, the inputs of the permutators of the first stage being directly connected electrically to the input terminals, the outputs of the permutators of the last stage being electrically connected directly to the output terminals, and between two successive stages, the outputs of each permutator of a stage of lower rank are electrically connected to respective ones of the inputs of each of the permutators of the stage of higher rank.

10. A panel according to claim 9, **characterised by** the fact that the permutators of order $n$ are disposed symmetrically about a longitudinal axis.

11. A panel according to claim 10, **characterised by** the fact that the permutators of order $n$ are disposed symmetrically about a transverse axis.

**Patentansprüche**

1. Verfahren zur Herstellung einer eineindeutigen und personalisierten elektrischen Verdrahtung zwischen N Drähten, die in ein Verbindungsgehäuse eintreten und N Drähten, die aus diesem austreten, **gekennzeichnet durch** die folgenden Schritte:

es wird eine Leiterplatte verwendet, die N Eingangsanschlüsse und N Ausgangsanschlüsse hat, welche über ein Netz von Spuren verbunden sind, und die eine Vielzahl von elementaren Verbindungsvorrichtungen umfaßt, welche zwei benachbarte, auf zwei Spuren liegende Eingänge mit zwei benachbarten, auf den zwei gleichen Spuren liegenden Ausgängen derart verbinden, daß die zwei Eingänge mit den zwei Ausgängen einerseits **durch** zwei direkte Verbindungen, die von Abschnitten dieser zwei Spuren gebildet sind, und andererseits **durch** zwei gekreuzte Zweigverbindungen elektrisch verbunden sind, damit jeder Eingangsanschluß mit allen Ausgangsanschlüssen und jeder Ausgangsanschluß mit allen Eingangsanschlüssen elektrisch verbunden ist, die genannte Platte **dadurch** personalisiert wird, daß in jeder elementaren Verbindungsvorrichtung entweder die direkten Verbindungen oder die Zweigverbindungen unterbrochen werden, um eine eineindeutige und personalisierte elektrische Verdrahtung zwischen den N Eingangsanschlüssen und den N Ausgangsanschlüssen der Platte zu erhalten, wobei die Anzahl und die Anordnung der Vorrichtungen derart gewählt sind, daß alle möglichen Verdrahtungskombinationen ermöglicht werden, und
die personalisierte Platte in dem Verbindungsgehäuse angebracht wird.

2. Leiterplatte für die Durchführung des Verfahrens nach Anspruch 1, **dadurch gekennzeichnet, daß** sie N Eingangsanschlüsse und N Ausgangsanschlüsse umfaßt, wobei die Eingangsanschlüsse und die Ausgangsanschlüsse durch ein Netz von Spuren verbunden sind, wobei die Spuren durch eine Vielzahl von elementaren Verbindungsvorrichtungen mit zwei Eingängen zwei Ausgängen, die zwischen benachbarten Abschnitten von zwei Spuren angeordnet sind, untereinander verbunden sind, wobei die zwei Eingänge einer Vorrichtung mit den zwei Ausgängen der Vorrichtung einerseits durch zwei direkte Verbindungen, die von den genannten Abschnitten gebildet sind, und andererseits durch zwei gekreuzte Zweigverbindungen elektrisch verbunden sind, damit jeder Eingangsanschluß mit allen Ausgangsanschlüssen und jeder Ausgangsanschluß mit allen Eingangsanschlüssen elektrisch verbunden ist, wobei die Anzahl und die Anordnung der Vorrichtungen derart gewählt sind, daß alle möglichen Verdrahtungskombinationen **dadurch** ermöglicht werden, daß in jeder elementaren Verbindungsvorrichtung entweder die direkten Verbindungen oder die Zweigverbindungen unterbrochen werden.

3. Platte nach Anspruch 2, **dadurch gekennzeichnet, daß** die Eingangsanschlüsse an einem Rand der Platte und die Ausgangsanschlüsse an einem anderen Rand, insbesondere dem gegenüberliegenden Rand angeordnet sind.

4. Platte nach einem der Ansprüche 2 oder 3, **dadurch gekennzeichnet, daß** Spurenabschnitte, die direkte Verbindungen oder gekreuzte Verbindungen einer Verbindungsvorrichtung bilden, übereinanderliegend an den gegenüberliegenden Seiten der Leiterplatte angeordnet sind.

5. Platte nach einem der Ansprüche 2 bis 4, **dadurch gekennzeichnet, daß** Verbindungen mit Hilfe von Durchkontaktierungen realisiert sind, die seitlich in Entfernung von den direkten Verbindungen oder den gekreuzten und mit letzteren verbundenen Verbindungen angeordnet sind.

6. Platte nach irgendeinem der Ansprüche 2 bis 5, **dadurch gekennzeichnet, daß** in jeder elementaren Verbindungsvorrichtung direkte Verbindungen oder Zweigverbindungen **dadurch** unterbrochen werden, daß Löcher durch die Platte hindurch ausgebildet werden.

7. Platte nach Anspruch 6, **dadurch gekennzeichnet, daß** die Löcher durch ein isolierendes Harz verschlossen sind.

8. Platte nach irgendeinem der Ansprüche 2 bis 7, **dadurch gekennzeichnet, daß** die elementaren Verbindungsvorrichtungen über eine Vielzahl von Stufen von Umschaltern der Ordnung n, die zwischen den Eingängen und den Ausgängen angeordnet sind, verteilt sind, wobei ein Umschalter der Ordnung n ermöglicht, eine eineindeutige Verdrahtung zwischen n Eingängen und n Ausgängen herzustellen.

9. Platte nach Anspruch 8, **dadurch gekennzeichnet, daß** sie drei Stufen von Umschaltern der Ordnung n umfaßt, wobei die Eingänge der Umschalter der ersten Stufe direkt mit den Eingangsanschlüssen elektrisch verbunden sind, wobei die Ausgänge der Umschalter der letzten Stufe direkt mit den Ausgangsanschlüssen elektrisch verbunden sind, und zwischen zwei aufeinanderfolgenden Stufen die Ausgänge eines jeden Umschalters der Stufe niedrigeren Rangs jeweils mit einem Eingang eines jeden der Umschalter der Stufe höheren Rangs elektrisch verbunden sind.

10. Platte nach Anspruch 9, **dadurch gekennzeichnet, daß** die Umschalter der Ordnung n in bezug auf eine Längsachse symmetrisch angeordnet sind.

11. Platte nach Anspruch 10, **dadurch gekennzeichnet, daß** die Umschalter der Ordnung n in bezug auf eine Querachse symmetrisch angeordnet sind.

FIG.1

FIG.2

FIG.3

FIG.4

FIG.5

FIG.6

FIG.7

FIG.9

FIG.8

R0    R1    R2    R3    R4

FIG.10

Directe        Inverse

FIG.11

14

FIG.12

FIG.13

FIG.14

FIG.15A

FIG.15B

FIG.16

**RÉFÉRENCES CITÉES DANS LA DESCRIPTION**

**Documents brevets cités dans la description**

- WO 0025392 A